(19) Europäisches Patentamt

European Patent Office

Office européen des brevets

(11) **EP 1 353 234 A1**

(12) **EUROPEAN PATENT APPLICATION**

(43) Date of publication:
**15.10.2003 Bulletin 2003/42**

(51) Int Cl.$^7$: **G03F 7/20**, G03F 9/00

(21) Application number: **03252285.6**

(22) Date of filing: **10.04.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **12.04.2002 EP 02252625**

(71) Applicant: **ASML Netherlands B.V.**
**5503 LA Veldhoven (NL)**

(72) Inventors:
• **Van de Moosdijk, Michael Josephus Evert**
**5623 HX Eindhoven (NL)**

• **Simon, Klaus**
**5655 CP Eindhoven (NL)**
• **Van den Brink, Enno**
**5621 GE Eindhoven (NL)**

(74) Representative: **Leeming, John Gerard**
**J.A. Kemp & Co.,**
**14 South Square,**
**Gray's Inn**
**London WC1R 5JJ (GB)**

(54) **Device manufacturing method, device manufactured thereby and computer program**

(57) To print layers of extended devices, that is devices extending over more than one target portion or die, a projection field is selected to minimize stitching errors. Preferably, the selection of the projection field is based on data characterizing the projection lens to be used and the projection field is selected so as minimize the difference between positional errors in the projected image on opposite sides of the field.

**Fig. 3**

EP 1 353 234 A1

# Description

The present invention relates to a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto first and second target portions of the layer of radiation-sensitive material, said target portions adjoining along an edge.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (*e.g.* an Si, GaAs, InP, AlTiC or SiGe wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In the past, many devices manufactured by lithographic techniques have been smaller than or the same size as the target area printable by a lithographic apparatus in a single exposure or scan. However, increasingly it is desirable to be able to create devices, such as radiation sensors, liquid crystal displays or devices that are fabricated along an exact line across the substrate, that are larger than the largest printable target area of a lithographic apparatus. Such devices are referred to as extended devices. To do this, it is necessary to use multiple adjoining exposures which must be aligned with high accuracy. This process is commonly referred to as "stitching". There are a number of sources of error in a lithographic apparatus which may lead to misalignment of adjoining exposures on a substrate (stitching or butting errors). These sources of error include: stage position repeatability, which may be affected by X, Y and θ resolution in the servo systems, the resolution of the interferometer systems measuring stage position and errors in mirror maps; stage leveling; stage dynamics; wafer and mask holder flatness; and projection lens distortion. Each of these sources of errors needs to be minimized or compensated for to ensure that stitching error requirements are met.

It is an object of the present invention to minimize or alleviate at least some of the above-mentioned sources of error in aligning adjacent exposures in a device manufacturing method.

This and other objects are achieved according to the invention in a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto first and second target portions of the layer of radiation-sensitive material, said target portions adjoining along an edge,

characterized in that:

in said step of projecting, the size and position of the projected field within the total field of said projection system are selected so as to minimize the difference between positional errors along said edge of the images projected onto said first and second target portion.

By appropriately selecting the size and location of the projected field to minimize the difference between positional errors in the images projected onto the first and second target portions where those target portions adjoin, stitching errors are minimized. Conventionally, the selection of the size and location of the projected field is driven by throughput considerations and the requirements of the mask pattern. In general, the projected field will be as large as possible so that a device can be printed in as small a number of exposures as possible. However, positional distortions in the projected image are generally greatest at the edge of the projectable field and so selecting a maximum size projection field leads to the potential for large stitching errors. The present invention, by appropriately selecting a reduced field for projection reduces the number of stitching errors. Although use of a smaller field may reduce throughput of printed devices, by reducing stitching errors the proportion of correctly functioning devices increases and so the net throughput of correctly functioning devices can be improved. The number, size and orientation of parts into which a device is broken down for imaging may be selected according to the contents of the pattern to be imaged as well as positional distortions in the projected field. Not all the parts need be the same size and shape.

The edge along which the target portions overlap may be referred to as a stitch boundary and the images at this boundary may overlap slightly or abut without overlap.

Preferably, the selection of the reduced projection field is based on data characterizing positional distortions in the projection lens to be used and the projected field can be selected by finding a field in which the difference between positional errors on opposite sides of the field are minimized. This determination may be carried out in advance of a given exposure series.

Further reductions in stitching errors can be obtained by optimizing the sequence of exposures and by optimizing leveling over the whole apparatus.

The invention also provides a computer program for selecting an optimum size and location for a projection field within the total field of a projection system for a device manufacturing method using a lithographic projection apparatus in which images are projected onto first and second target portions of a radiation-sensitive layer provided on a substrate using said projection system, said first and second target portions adjoining along an edge, said computer program comprising program code means that, when executed on a computer system, instruct the computer system to perform the steps of:

> determining, by reference to data representing positional displacements of projected images across the maximum field of a projection system used in said step of projecting, the differences between positional displacements on opposite sides of a plurality of reduced fields within said maximum field, said plurality of reduced fields having different sizes, aspect ratios, and/or locations within said maximum field; and
> selecting one of said plurality of reduced fields having minimum differences between positional displacements as said reduced field.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 431, 410, 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

> Figure 1 depicts a lithographic projection apparatus used in a method according to an embodiment of the invention;
> Figure 2 is an example of a vector plot of the lens signature of the projection system of a lithographic projection apparatus;
> Figure 3 is an example of a higher order lens signature showing an optimum field used in a method according to the present invention;
> Figure 4 is a diagram showing a stitching offset applied in a method according to the present invention;
> Figure 5 is a diagram showing step patterns usable in a method according to the present invention; and
> Figure 6 is a diagram showing the use of several different fields of different sizes and orientations to image a device.

In the Figures, corresponding reference symbols indicate corresponding parts.

Embodiment 1

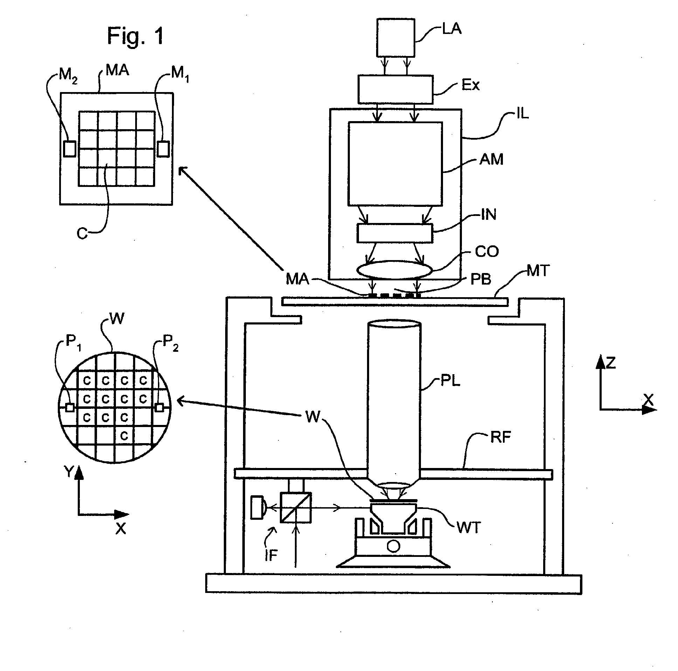

Figure 1 schematically depicts a lithographic projection apparatus that may be used in a device manufacturing method according to a particular embodiment of the invention. The apparatus comprises:

- a radiation system Ex, IL, for supplying a projection beam PB of radiation (*e.g.* DUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W *(e. g.* a resist-coated silicon wafer), and connected to second positioning means for accurately positioning the substrate with respect to item PL;

· a projection system ("lens") PL *(e.g.* a refractive lens system) for imaging an irradiated portion of the mask MA onto a target portion C *(e.g.* comprising one or more dies) of the substrate W.

As here depicted, the apparatus is of a transmissive type *(e.g.* has a transmissive mask). However, in general, it may also be of a reflective type, for example *(e.g.* with a reflective mask). Alternatively, the apparatus may employ another kind of patterning means, such as a programmable mirror array of a type as referred to above.

The source LA *(e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V - Mv,$ in which $M$ is the magnification of the lens PL (typically, $M$ = 1/4 or 1/5). In this manner, a relatively large target portion C can be exposed, without having to compromise on resolution.

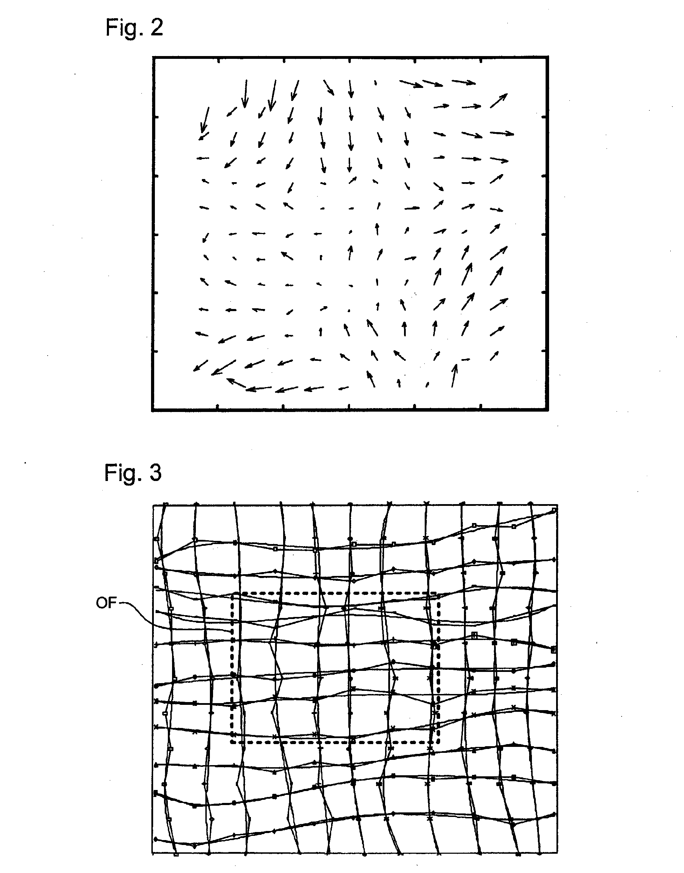

Figure 2 is an example of a vector plot characterizing the distortions introduced by the projection lens when projecting a mask pattern onto a substrate. In the Figure, the direction and magnitude of each arrow indicates the positional error of a point in the image nominally positioned at the tail of the arrow. Note though that the size of distortions is substantially exaggerated in this Figure. The lens signature represented by this plot is different for each projection system PL but can be measured and recorded by well-known techniques. It should be noted that in the process of measuring distortions introduced by the projection lens, distortions caused by the clamping of the measurement reticle and distortions of the measurement reticle itself will be measured too. Distortions of the measurement reticle can be subtracted from the measured plot before it is used in the method of the invention. Distortions due to clamping should also be subtracted, at least to the extent that they will differ from distortions of production reticle due to their clamping.

Figure 3 is a higher-order plot of the same lens signature. It is calculated from the vector data and represents how an ideal line would be distorted in the projected image. From the higher-order fitted data, it is possible to determine an optimum field within the total available field such that the difference between the positional errors between points on opposite boundaries of the optimum field are minimized. In this determination, 2nd and optionally higher order distortions in the projected image are taken into account. When adjacent fields are printed using the optimum field for each exposure, the stitching errors will be correspondingly minimized. Figure 3 illustrates an example of such an optimum field OF for the example lens signature.

The optimum field OF can be determined by calculating and comparing left and right and/or top and bottom distortion vectors for different field sizes and locations. The optimum field size and location can then readily be selected. It should be noted however that the optimization may include additional constraints than minimizing stitching errors since in many cases the minimum stitching error would be achieved with a zero field size. Thus, the optimization may be constrained to find the field of a given minimum size and/or aspect ratio that provides minimum stitching errors. If the pattern that is to be printed is such that stitching accuracy is more critical in some parts than others, the differences between positional errors may be weighted according to the criticality of stitching errors in different parts of the boundary, before selection of the optimum field size and location.

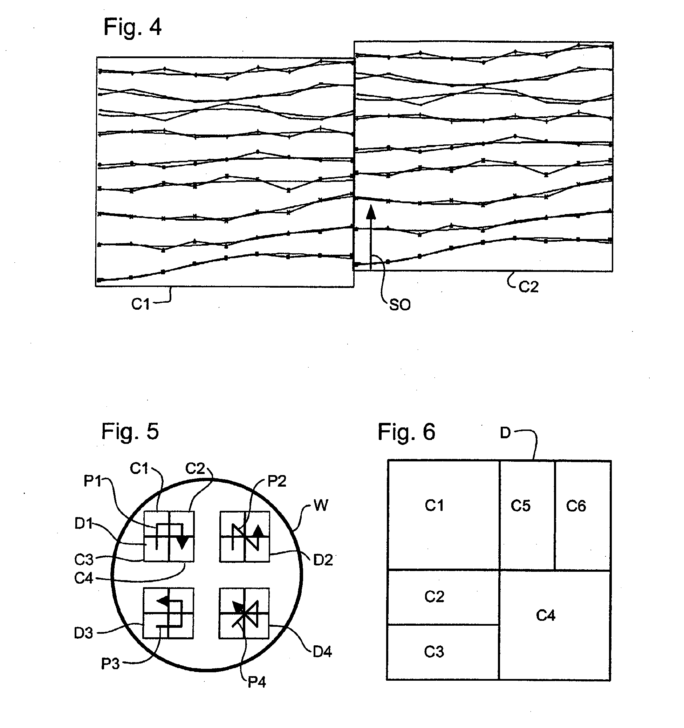

It should also be noted that the several images used to make up a single device may be have different field sizes. Figure 6 shows a device D made up of images C1 to C6 which are of two different sizes and two different orientations. The sizes and orientations of the image fields for the different exposures are selected according to the details of the pattern of the whole device as well as the distortions of the projection lens.

After calculation of the optimum field size and location, there may be a residual difference between the positional errors on opposite sides of the field. In many cases the differences will have a non-zero average, meaning that one side of the projected image in the field is shifted in one direction. An improved match along the edge can therefore be obtained by shifting one exposure by an appropriate amount to compensate. This is shown in Figure 4 which shows the 2$^{nd}$-order plot of two adjoining target portions C1, C2. It will be seen that the match along the join is improved by a relative shift of target portion C2 in the direction indicated by the arrow SO.

It will be appreciated that applying a stitching offset provides the greatest advantage where the difference in positional errors on opposite sides of the image field is in the same direction along all or most of the edge. If the difference in positional errors in different parts of the edge is in different directions, a stitching offset may provide less or no improvement. Thus, in selected of an optimum field size and location, the improvement obtainable by a stitching offset should also be taken into account.

In order to further minimize stitching errors, the substrate table positioning repeatability may be characterized by performing a series of test exposures or other measurements to obtain data characterizing X and Y stepping errors of the wafer table server system. Errors in table positioning will, in general, include random and systematic components. The tests are repeated to identify the systematic errors which are to be taken account of in determination of the optimum exposure sequence. Such errors may derive from the wafer table positioning and control system as well as the interferometric displacement measuring system IF. Preferably, the test exposures are arranged to take account of all possible sources of errors. The test exposures can be used to derive a table positioning fingerprint comparable to the lens signature for a given apparatus. The fingerprint can in turn be used to derive a stepping correction matrix, $f_i$, such that:

$$f_i = (\Delta x, \Delta y, \Delta \varphi, \Delta \psi, \Delta \tau)$$

where $\Delta x$, $\Delta y$ represent position errors, $\Delta \varphi$ represents rotational error, $\Delta \psi$ represent leveling correction and $\Delta \tau$ step pattern specific corrections.

Given the X and Y stepping error characterization data, an optimization routine can readily determine the appropriate order to carry out the exposures necessary to build up a device whilst minimizing stitching errors caused by stage positioning errors. To date, exposure orders have been optimized for throughput only.

Figure 5 shows a substrate W on which devices D1 to D4 are to be printed. Each device is made up of target areas C1 to C4. Possible paths P1 to P4 to be followed to print the different target areas are also shown. It will be appreciated that the optimum orders for printing different devices on a substrate may be different if the X and Y stepping errors are different in different areas of the substrate. According to the invention, it is preferable that the step pattern is arranged so that the exposures necessary to complete an extended device are all done before the next device is begun and that the total distance traveled to complete an extended device is minimized.

It is conventional, when performing an exposure to position the substrate so that the target portion is optimally positioned in the focal plane of the projection lens PL. This process is known as leveling and may be carried out on-the-fly, that is during an exposure, using a level sensor that provides a real-time measurement of the position of the surface of the substrate. Alternatively, the surface contour of the wafer may be measured in advance and optimum height (Z) positions and tilts (Rx, Ry) of the substrate during a scan calculated. The leveling process may be seen as determining an optimum plane, representing an average of the substrate contour, that is to be positioned in the focal plane of the projection system PL. Conventionally such a plane has been determined separately for each exposure. According to the invention, the optimum plane is determined for the whole of an extended device.

It will be appreciated that all of the optimization procedures of the invention may be carried out in real-time, during the course of a series of exposures, or in advance based an previously determined characteristics of the lithography apparatus and, where relevant, data of the patterns to be imaged and the substrate to be exposed. The optimization procedures may be effected by a computer system forming part of the control system of the lithographic apparatus or by a separate computer system.

It will further be appreciated that the different optimizations described above may be used individually or on various combination as desired.

Whilst specific embodiments of the invention have been described above, it will be appreciated that the invention may be practiced otherwise than as described. The description is not intended to limit the invention.

**Claims**

1.  A device manufacturing method comprising the steps of:

    -   providing a substrate that is at least partially covered by a layer of radiation-sensitive material;
    -   providing a projection beam of radiation using a radiation system;
    -   using patterning means to endow the projection beam with a pattern in its cross-section;
    -   projecting the patterned beam of radiation onto first and second target portions of the layer of radiation-sensitive material, said target portions adjoining along an edge,

    **characterized in that**:

    in said step of projecting, the size and position of the projected field within the total field of said projection system are selected so as to minimize the difference between positional errors along said edge of the images projected onto said first and second target portion.

2.  A method according to claim 1 wherein said size and position of the projected field are selected by the steps of:

    determining, by reference to data representing positional displacements of projected images across the maximum field of a projection system used in said step of projecting, the differences between positional displacements on opposite sides of a plurality of reduced fields within said maximum field, said plurality of reduced fields having different sizes, aspect ratios, and/or locations within said maximum field; and
    selecting one of said plurality of reduced fields having minimum differences between positional displacements as said reduced field.

3.  A method according to claim 1 or 2 further comprising the step of offsetting the relative position on said substrate of the image projected onto one of said first and second target portions from a nominal position so as to improve alignment between the images projected onto said first and second target portions.

4.  A method according to claim 1, 2 or 3 wherein said device is an extended device, one layer of which is printed by exposing a plurality of adjoining target portions.

5.  A method according to claim 4 wherein the order of exposing said plurality of adjoining target portions is selected to minimize errors at the joins between said adjoining target portions.

6.  A method according to claim 4 or 5 wherein in said step of projecting, the position and orientation of said substrate relative to the focal plane of a projection system used in said step of projecting, is optimized over the whole extended device.

7.  A device manufactured according to the method of any one of the preceding claims.

8.  A computer program comprising program code means for instructing a lithographic apparatus to perform the steps of any one of the preceding claims.

9.  A computer program for selecting an optimum size and location for a projection field within the total field of a projection system for a device manufacturing method using a lithographic projection apparatus in which images are projected onto first and second target portions of a radiation-sensitive layer provided on a substrate using said projection system, said first and second target portions adjoining along an edge, said computer program comprising program code means that, when executed on a computer system, instruct the computer system to perform the steps of:

    determining, by reference to data representing positional displacements of projected images across the maximum field of a projection system used in said step of projecting, the differences between positional displacements on opposite sides of a plurality of reduced fields within said maximum field, said plurality of reduced fields having different sizes, aspect ratios, and/or locations within said maximum field; and
    selecting one of said plurality of reduced fields having minimum differences between positional displacements as said reduced field.

Fig. 1

Fig. 2

Fig. 3

## Fig. 4

C1

SO

C2

## Fig. 5

P1  C1  C2  P2

D1  W

C3  D2

C4

D3

P3  D4

P4

## Fig. 6

D

| C1 | C5 | C6 |
| C2 | C4 |  |
| C3 |  |  |

European Patent
Office

**EUROPEAN SEARCH REPORT**

Application Number

EP 03 25 2285

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.7) |
| X | US 5 298 761 A (AOKI ATSUYUKI ET AL) 29 March 1994 (1994-03-29) * claim 1 * | 1-9 | G03F7/20 G03F9/00 |
| X | US 5 281 996 A (BRUNING JOHN H ET AL) 25 January 1994 (1994-01-25) * column 6, line 50 - line 58; figure 9 * | 1-9 | |
| X | US 6 204 912 B1 (FUJIMORI NOBUTAKA ET AL) 20 March 2001 (2001-03-20) * figures 14,15 * | 1-9 | |
| X | US 2002/024714 A1 (AKLINT TORBJORN ET AL) 28 February 2002 (2002-02-28) * paragraphs [0052],[0060],[0074],[0103] * | 1-9 | |
| A | US 5 773 836 A (HARTLEY JOHN GEORGE) 30 June 1998 (1998-06-30) * figure 1 * | 1-9 | |
| A | PATENT ABSTRACTS OF JAPAN vol. 017, no. 621 (P-1645), 16 November 1993 (1993-11-16) -& JP 05 197158 A (NIKON CORP), 6 August 1993 (1993-08-06) * abstract * | 1-9 | TECHNICAL FIELDS SEARCHED (Int.Cl.7) G03F |

The present search report has been drawn up for all claims

| Place of search | Date of completion of the search | Examiner |
|---|---|---|
| MUNICH | 18 August 2003 | van Toledo, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**     EP 03 25 2285

This annex lists the patent family members relating to the patent documents cited in the above-mentioned European search report.
The members are as contained in the European Patent Office EDP file on
The European Patent Office is in no way liable for these particulars which are merely given for the purpose of information.

18-08-2003

| Patent document cited in search report | | Publication date | Patent family member(s) | | Publication date |
|---|---|---|---|---|---|
| US 5298761 | A | 29-03-1994 | JP | 3383994 B2 | 10-03-2003 |
| | | | JP | 5197158 A | 06-08-1993 |
| US 5281996 | A | 25-01-1994 | NONE | | |
| US 6204912 | B1 | 20-03-2001 | JP | 9298155 A | 18-11-1997 |
| | | | JP | 10062809 A | 06-03-1998 |
| US 2002024714 | A1 | 28-02-2002 | JP | 2002372790 A | 26-12-2002 |
| | | | AU | 2755599 A | 20-09-1999 |
| | | | AU | 2755699 A | 20-09-1999 |
| | | | AU | 2755799 A | 20-09-1999 |
| | | | AU | 2756899 A | 20-09-1999 |
| | | | AU | 2756999 A | 20-09-1999 |
| | | | AU | 2757099 A | 20-09-1999 |
| | | | AU | 3284299 A | 20-09-1999 |
| | | | CN | 1292102 T | 18-04-2001 |
| | | | CN | 1292103 T | 18-04-2001 |
| | | | EP | 1060439 A1 | 20-12-2000 |
| | | | EP | 1060440 A1 | 20-12-2000 |
| | | | EP | 1060441 A1 | 20-12-2000 |
| | | | EP | 1060442 A1 | 20-12-2000 |
| | | | EP | 1060443 A1 | 20-12-2000 |
| | | | JP | 2002506230 T | 26-02-2002 |
| | | | JP | 2002506231 T | 26-02-2002 |
| | | | JP | 2002506232 T | 26-02-2002 |
| | | | JP | 2002506233 T | 26-02-2002 |
| | | | JP | 2002506234 T | 26-02-2002 |
| | | | JP | 2002506235 T | 26-02-2002 |
| | | | JP | 2002506236 T | 26-02-2002 |
| | | | WO | 9945435 A1 | 10-09-1999 |
| | | | WO | 9945436 A1 | 10-09-1999 |
| | | | WO | 9945437 A1 | 10-09-1999 |
| | | | WO | 9945438 A1 | 10-09-1999 |
| | | | WO | 9945439 A1 | 10-09-1999 |
| | | | WO | 9945440 A1 | 10-09-1999 |
| | | | WO | 9945441 A1 | 10-09-1999 |
| | | | US | 6428940 B1 | 06-08-2002 |
| | | | US | 6399261 B1 | 04-06-2002 |
| | | | US | 6373619 B1 | 16-04-2002 |
| | | | US | 6285488 B1 | 04-09-2001 |
| | | | US | 6504644 B1 | 07-01-2003 |
| US 5773836 | A | 30-06-1998 | NONE | | |
| JP 05197158 | A | 06-08-1993 | JP | 3383994 B2 | 10-03-2003 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**                    EP 03 25 2285

This annex lists the patent family members relating to the patent documents cited in  the above-mentioned European search report.
The members are as contained in the European Patent Office EDP file on
The European Patent Office is in no way liable for these particulars which are merely  given for the purpose of information.

18-08-2003

| Patent document cited in search report | Publication date | Patent family member(s) | Publication date |
|---|---|---|---|
| JP 05197158 A | | US 5298761 A | 29-03-1994 |

For more details about this annex : see Official Journal of the European Patent Office, No. 12/82